(19) Europäisches Patentamt
European Patent Office
Office européen des brevets

(11) **EP 2 859 367 B1**

(12) **EUROPÄISCHE PATENTSCHRIFT**

(45) Veröffentlichungstag und Bekanntmachung des Hinweises auf die Patenterteilung:
**12.10.2016 Patentblatt 2016/41**

(21) Anmeldenummer: **13724603.9**

(22) Anmeldetag: **24.05.2013**

(51) Int Cl.:
*G01K 13/00* (2006.01)          *H01M 10/48* (2006.01)
*G01R 31/36* (2006.01)          *H01M 10/42* (2006.01)

(86) Internationale Anmeldenummer:
**PCT/EP2013/060758**

(87) Internationale Veröffentlichungsnummer:
**WO 2013/182439 (12.12.2013 Gazette 2013/50)**

(54) **BATTERIESYSTEM UND ZUGEHÖRIGES VERFAHREN ZUR ERMITTLUNG DES INNENWIDERSTANDES VON BATTERIEZELLEN ODER BATTERIEMODULEN DES BATTERIESYSTEMS**

BATTERY SYSTEM AND ASSOCIATED METHOD FOR DETERMINING THE INTERNAL RESISTANCE OF BATTERY CELLS OR BATTERY MODULES OF SAID BATTERY SYSTEM

SYSTÈME DE BATTERIE ET PROCÉDÉ CORRESPONDANT DE DÉTERMINATION DE LA RÉSISTANCE INTERNE D'ÉLÉMENTS DE BATTERIE OU DE MODULES DE BATTERIE DU SYSTÈME DE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.06.2012 DE 102012209660**

(43) Veröffentlichungstag der Anmeldung:
**15.04.2015 Patentblatt 2015/16**

(73) Patentinhaber:
• **Robert Bosch GmbH**
**70442 Stuttgart (DE)**
• **Samsung SDI Co., Ltd.**
**Yongin-si, Gyeonggi-do 446-577 (KR)**

(72) Erfinder: **FINK, Holger**
**70567 Stuttgart (DE)**

(74) Vertreter: **Bee, Joachim**
**Robert Bosch GmbH**
**C/IPE**
**Wernerstrasse 1**
**70469 Stuttgart (DE)**

(56) Entgegenhaltungen:
**DE-A1-102009 002 465          DE-A1-102010 027 864**
**US-A1- 2012 119 745**

**Beschreibung**

Die vorliegende Erfindung betrifft ein Verfahren zur Ermittlung des Innenwiderstandes von Batteriezellen oder von Batteriemodulen einer Batterie, die einen Batteriemodulstrang mit einer Mehrzahl von in Serie geschalteten Batteriemodulen aufweist. Insbesondere betrifft die Erfindung ein Verfahren zur Ermittlung des Innenwiderstandes von Batteriezellen oder von Batteriemodulen einer derartigen Batterie, deren Batteriemodule dazu ausgebildet sind, mittels von Steuersignalen wahlweise in einen zugeschalteten Zustand, in dem ein jeweiliges Batteriemodul zu einer Ausgangsspannung des Batteriemodulstrangs beiträgt, oder einen nicht zugeschalteten Zustand, in dem das jeweilige Batteriemodul von dem Batteriemodulstrang entkoppelt ist, schaltbar zu sein. Ferner betrifft die Erfindung ein Batteriesystem, das dazu ausgebildet ist, das erfindungsgemäße Verfahren durchzuführen.

Stand der Technik

Aus dem Stand der Technik sind Batterien für den Einsatz in Hybrid- und Elektrofahrzeugen bekannt, die als Traktionsbatterien bezeichnet werden, da sie für die Speisung elektrischer Antriebe eingesetzt werden.

Die Druckschrift DE 10 2009 002465 A1 offenbart ein Verfahren und eine Vorrichtung zur Ermittlung des Innenwiderstands einer Batteriezelle einer Batterie, das sowohl bei Ladevorgängen als auch bei Entladevorgängen als auch in Phasen anwendbar ist, in den die Batterie keine elektrische Leistung abgibt oder aufnimmt, wobei in der Batterie ein resistives Zellbalancing zum

Ausgleich der Ladezustände der Batteriezellen ausgeführt wird, bei dem der Batteriezelle über einen Widerstand Energie entnommen wird.

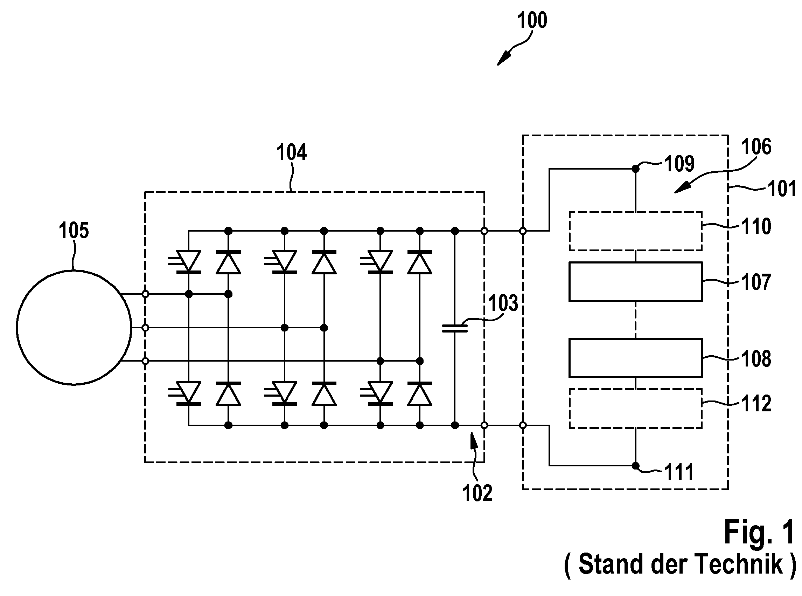

In früheren Patentanmeldungen der Anmelderin werden Antriebssysteme, die jeweils ein Batteriesystem mit einer stufig einstellbaren Ausgangsspannung aufweisen und heute beispielsweise in Elektro- und Hybridfahrzeugen oder auch in stationären Anwendungen wie bei der Rotorblattverstellung von Windkraftanlagen zum Einsatz kommen, beschrieben. Ein Beispiel eines solchen Batteriesystems ist in der Figur 1 dargestellt.

Ein Batteriesystem 100 umfasst eine Batterie 101, die an einen Gleichspannungszwischenkreis 102, der einen Kondensator 103 umfasst, angeschlossen ist. Der Gleichspannungszwischenkreis 102 ist in einem von dem Batteriesystem 100 umfassten Pulswechselrichter 104 integriert, über den an drei Ausgängen jeweils mittels zwei schaltbaren Halbleiterventilen (nicht gekennzeichnet) und zwei Dioden (nicht gekennzeichnet) gegeneinander phasenversetzte Sinusspannungen für den Betrieb eines dreiphasigen Elektromotors (elektrischer Antriebsmotor) 105 bereitgestellt werden. Die Kapazität des Kondensators 103 ist dabei hinreichend groß ausgelegt, um die Spannung im Gleichspannungszwischenkreis 103 für eine Zeitdauer, in der eines der schaltbaren Halbleiterventile durchgeschaltet wird, zu stabilisieren.

Die Batterie 101 umfasst einen Batteriemodulstrang 106 mit mehreren in Reihe geschalteten Batteriemodulen, von denen in der Zeichnung nur zwei Batteriemodule 107, 108 dargestellt sind. Zwischen dem Batteriemodul 107 und einem positiven Pol 109 des Batteriemodulstranges 106, der in diesem Fall ein positives Batterieterminal bildet, ist eine Lade- und Trenneinrichtung 110 geschaltet. Optional kann zusätzlich zwischen dem Batteriemodul 108 und einem negativen Pol 111 des Batteriemodulstranges 106, der in diesem Fall ein negatives Batterieterminal bildet, eine Trenneinrichtung 112 geschaltet werden. Die Batteriemodule 107, 108 können Koppeleinrichtungen (nicht dargestellt) aufweisen, mittels denen sie wahlweise separat jeweils zum Batteriemodulstrang 106 zugeschaltet oder von dem Batteriemodulstrang 106 entkoppelt, das heißt überbrückt werden können, um auf diese Weise ein Batteriesystem mit stufig einstellbarer Ausgangsspannung zu implementieren.

Um die Sicherheit eines solchen Batteriesystems zu gewährleisten, die Leistungsfähigkeit der Batteriezellen auszuschöpfen und die Lebensdauer der Batteriezeilen zu erhöhen, werden in Traktionsbatterien Batteriemanagementsysteme eingesetzt. Kernfunktion dieser Batteriemanagementsysteme ist eine sogenannte Batteriezustandserkennung, welche den aktuellen Zustand der Batteriezellen ermittelt. Eine der wesentlichen Informationen ist dabei der Innenwiderstand der Batteriezellen, welcher als Funktion des Ladezustands, der Temperatur der Batteriezellen und deren Alterungszustand ermittelt wird. Ein solches Verfahren zur Charakterisierung von Batteriezellen ist in der VDA-Initiative "Energy Storage System for HEV" sowie im Entwurf der ISO 12405 beschrieben.

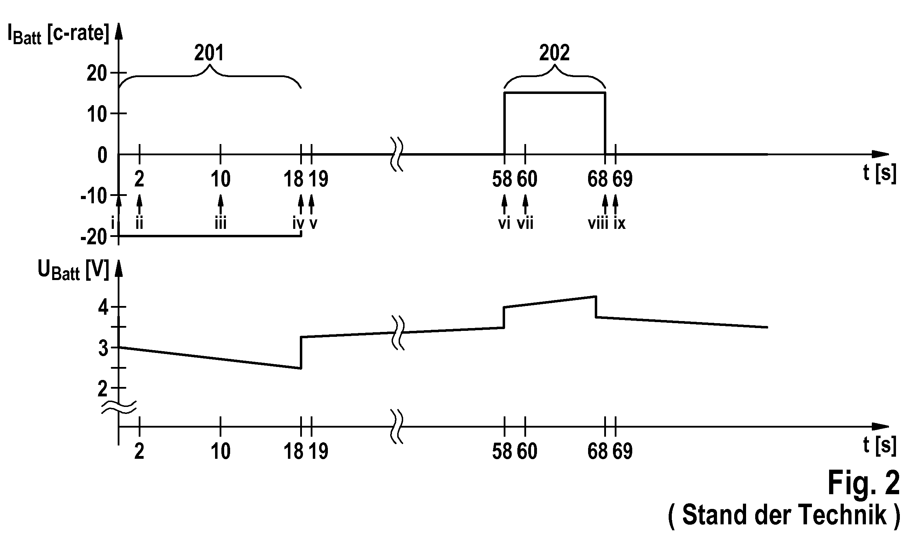

Das Grundprinzip dieses Verfahrens ist in Figur 2 dargestellt. Dabei zeigt Figur 2 beispielhafte Spannungsänderungen einer Batteriespannung $U_{Batt}$, die während eines pulsförmigen Lade- und Entladestroms $I_{Batt}$ der Batterie ausgewertet wird. Dabei ist der Strom $I_{Batt}$ in Einheiten einer Ladungsrate c-rate ("current rate") aufgetragen. Mit dem Bezugszeichen 201 ist ein Zeitraum einer Entladung der Batterie und mit dem Bezugszeichen 202 ein Zeitraum einer Ladung der Batterie gekennzeichnet. Verfahrensgemäß wird der Innenwiderstand $R_i$ der Batteriezellen direkt aus den Spannungs- und Stromdifferenzen zweier betrachteter Zeitpunkte ermittelt. Dabei sind in Figur 2 die Messzeitpunkte für die jeweiligen Messungen der Batteriespannung $U_{Batt}$ mit römischen Ziffern nummeriert. Die Indizes der im Folgenden angegebenen Spannungs- und Stromwerte beziehen sich auf diese Messzeitpunkte. Als Beispiel ergibt sich der Innenwiderstand für eine 10 Sekunden dauernde Entladung durch Auswertung der Spannungs- und Stromwerte zu den Messzeitpunkten (i) bei t=0s und (iii) bei t=10s zu

$$R_{i\_10s\_dch} = \frac{U_{III} - U_I}{I_{III}} \qquad (1).$$

Der Innenwiderstand für einen 10 Sekunden andauernden Ladevorgang kann entsprechend durch Auswertung der Spannungs- und Stromwerte zu den Zeitpunkten (vi) bei t=58s und (viii) bei t=68s gemäß (2) berechnet werden:

$$R_{i\_10s\_ch} = \frac{U_{VIII} - U_{VI}}{I_{VIII}} \qquad (2).$$

Dieses Verfahren wird bei der Charakterisierung der Zellen auf einem Prüfstand eingesetzt. Nachteilig an dem Verfahren ist, dass es schwierig ist, alle denkbaren realen Fahrsituationen, die beispielsweise bei einem Betrieb der Batterie in einem Kraftfahrzeug auftreten können, im Prüfstand vollständig abzubilden. Daher sind die auf diese Weise ermittelten Werte für den Innenwiderstand nur bedingt oder nur mit der Einschränkung einer begrenzten Genauigkeit für eine Weiterverarbeitung in einem Batteriemanagementsystem in einem Fahrzeug einsetzbar.

Offenbarung der Erfindung

Erfindungsgemäß wird ein Verfahren zur Ermittlung des Innenwiderstandes von Batteriezellen oder von Batteriemodulen einer Batterie zur Verfügung gestellt, die einen Batteriemodulstrang mit einer Mehrzahl von in Serie geschalteten Batteriemodulen aufweist. Die Batteriemodule sind jeweils dazu ausgebildet, mittels von Steuersignalen wahlweise in einen zugeschalteten Zustand, in dem ein jeweiliges Batteriemodul zu einer Ausgangsspannung des Batteriemodulstrangs beiträgt, oder einen nicht zugeschalteten Zustand, in dem das jeweilige Batteriemodul von dem Batteriemodulstrang entkoppelt ist, schaltbar zu sein. Das Verfahren weist grundsätzlich die folgenden Schritte auf:

a) Messen einer Spannung eines Batteriemoduls oder zumindest einer Batteriezelle eines Batteriemoduls zu einer ersten Zeit, zu der das Batteriemodul nicht zu dem Batteriemodulstrang zugeschaltet ist,
b) Zuschalten des Batteriemoduls zu dem Batteriemodulstrang, so dass aufgrund eines durch das Batteriemodul fließenden Stroms eine Änderung der Spannung des Batteriemoduls oder der zumindest einen Batteriezelle erfolgt,
c) Messen der Spannung des Batteriemoduls oder der Spannung der zumindest einen Batteriezelle zu einer zweiten Zeit, zu der das Batteriemodul eine vorbestimmte oder gewählte Zeitdauer zu dem Batteriemodulstrang zugeschaltet ist, und
d) Berechnen eines Widerstandswertes für den Innenwiderstand des Batteriemoduls beziehungsweise der zumindest einen Batteriezelle des Batteriemoduls anhand einer Differenz zwischen der zu der ersten Zeit gemessenen Spannung und der zu der zweiten Zeit gemessenen Spannung, und des Stromwertes des durch das Batteriemodul fließenden Stroms.

Ferner wird gemäß einem anderen Aspekt der Erfindung ein Batteriesystem mit einer Batterie geschaffen, das einen Batteriemodulstrang mit einer Mehrzahl von in Serie geschalteten Batteriemodulen aufweist, die jeweils mindestens eine Batteriezelle und eine ansteuerbare Koppeleinheit umfassen. Ferner weist das Batteriesystem eine zur Überwachung der Batteriemodule der Batterie vorgesehene Überwachungseinheit, insbesondere eine Zellüberwachungseinheit (CSC) ("Cell Supervision Circuit) auf, die dazu ausgebildet ist, Zellspannungen und/oder Batteriemodulspannungen zu messen. Außerdem weist das Batteriesystem mindestens eine mit dem Batteriemodulstrang verschaltete Strommesseinheit auf. Die Batteriemodule sind dazu eingerichtet, zur Erzeugung einer einstellbaren Batterie-Ausgangsspannung mittels der Koppeleinheiten jeweils selektiv dem Batteriemodulstrang zugeschaltet und wieder entkoppelt werden zu können. Ferner weist das Batteriesystem eine Steuerungs- und Ausleseeinheit, insbesondere eine in einem Batteriemanagementsystem integrierte Steuerungs- und Ausleseeinheit auf, die mit den Koppeleinheiten, mit der mindestens einen Überwachungseinheit, und mit der Strommesseinheit verbunden ist. Dabei ist das Batteriesystem dazu ausgebildet, das erfindungsgemäße Verfahren zur Ermittlung des Innenwiderstands von Batteriemodulen oder von Batteriezellen des Batteriesystems durchzuführen.

Somit werden erfindungsgemäß Mittel zu Verfügung gestellt, die vorteilhaft dazu ausgelegt sind, bei oder mit Hilfe von Batteriesystemen mit stufig einstellbarer Ausgangsspannung eine Ermittlung des Innenwiderstands von Batteriezellen durchzuführen. Es wird die spezifische Arbeitsweise eines Batteriesystems mit zuschaltbaren Batteriemodulen dazu genutzt, den Innenwiderstand von Batteriezellen möglichst einfach und genau ermitteln zu können. Ermöglicht wird dies insbesondere durch eine im Betrieb der Batterie vorgenommene sprungförmige positive oder negative Anregung in Form eines sprungförmigen Stromverlaufs, der an die Batteriezellen angelegt wird durch Zuschalten beziehungsweise Entkoppeln eines Batteriemoduls. Dabei wird eine Sprungantwort in Form des Spannungsverlaufs der Batteriezellen oder Batteriemodule aufgezeichnet und ausgewertet. Im Vergleich zum heutigen Stand der Technik ist das erfindungsgemäße Verfahren zur Ermittlung des Innenwiderstandes robuster und genauer. Dies ist auch dadurch bedingt, dass ermöglicht wird, die Messungen während realer Bedingungen im Betrieb der Batterie stattfinden zu lassen. Dieses Verfahren wird bevorzugt im Betrieb im Fahrzeug eingesetzt. Im Gegensatz finden die Verfahren gemäß dem Stand der Technik offline statt.

Nach einer Weiterbildung der Erfindung weist die erfindungsgemäße Batterie eine Mehrzahl von Batteriemodulsträngen auf und ist dazu eingerichtet, durch Ansteuerung der Koppeleinheiten mittels der Batteriemodulstränge zueinander phasenversetzte Wechselspannungen, insbesondere zum Betrieb eines Dreiphasen-Elektromotors zu erzeugen.

Dabei kann auf besonders günstige Weise die Funktionsweise eines Batteriedirektkonverters ausgenutzt werden, wobei zur Erzeugung der phasenversetzten Wechselspannungen vorgenommene Zuschaltungen und Entkopplungen von Batteriemodulen des Batteriedirektkonverters dazu dienen, das erfindungsgemäße Verfahren durchzuführen.

Gemäß einer Ausführungsform des erfindungsgemäßen Verfahrens wird der Stromwert des durch das Batteriemodul fließenden Stroms, der zur Berechnung des Widerstandswertes verwendet wird, zu der zweiten Zeit gemessen.

Das Verfahren kann quasi in jeder Betriebssituation angewendet werden. Insbesondere kann das Verfahren während eines Ladevorgangs der Batterie oder während eines Entladevorgangs der Batterie durchgeführt werden.

Gemäß einer Weiterbildung der Erfindung wird ferner der Stromverlauf des Batteriestroms während des zugeschalteten Zustands überwacht, bei dem eine Messung zur Widerstandsbestimmung durchgeführt wird. Genauer gesagt wird dabei ermittelt, ob die Höhe einer Änderung des während der Zeitdauer, in der das Batteriemodul dem Batteriemodulstrang zugeschaltet ist, durch das Batteriemodul fließenden Stroms einen vorbestimmten Grenzwert überschreitet. In dem Fall, dass der Grenzwert überschritten wird, wird die aktuelle Spannungsmessung verworfen. Das Verfahren kann wiederholt werden, um daraufhin Messungen mit hinreichend stabilem Strom durchzuführen.

Dadurch kann vorteilhaft die Zuverlässigkeit der berechneten Widerstandswerte weiter verbessert werden.

Gemäß einer besonders günstigen Ausführungsform der Erfindung ist vorgesehen, dass eine während der vorbestimmten Zeitdauer auftretende Veränderung der Leerlaufspannung des Batteriemoduls beziehungsweise der Leerlaufspannung der zumindest einen Batteriezelle ermittelt wird. Daraufhin wird gegebenenfalls der bei der Berechnung des Widerstandswertes verwendete Differenzspannungswert um den Wert der ermittelten Veränderung korrigiert. Auf diese Weise kann die Genauigkeit des Verfahrens beträchtlich erhöht werden.

Es wird bevorzugt, dass beim Betrieb der Batterie wenigstens zeitweise die verfahrensgemäßen Schritte mehrfach oder sogar permanent durchgeführt werden, bei unterschiedlichen Randbedingungen, wie Ladezustand, Temperatur, Höhe des Lade- oder Entladestroms, und/oder mit einer jeweils unterschiedlich gewählten Zeitdauer zwischen der ersten Spannungsmessung und der zweiten Spannungsmessung.

Dadurch wird ermöglicht, eine mit der Einsatzdauer der Batterie immer vollständigere und genauere Charakterisierung der Batterie mit dem dazugehörigen Innenwiderstand aller einzelnen Batteriemodule und/oder Batteriezellen zu erhalten. Bevorzugt werden die während der mehrfachen Durchführungen des Verfahrens ermittelten Messdaten in Form eines Innenwiderstands-Kennfelds abgelegt, wobei das Kennfeld ständig erweitert und aktualisiert werden kann.

Gemäß einer Ausführungsform der Erfindung werden ferner, nachdem die Messung der Spannung zu der zweiten Zeit durchgeführt wurde und bevor das Batteriemodul wieder in den nicht zugeschalteten Zustand geschaltet wird, eine oder mehrere weitere Messungen der Spannung des Batteriemoduls beziehungsweise der Spannung der zumindest einen Batteriezelle des Batteriemoduls vorgenommen. Basierend auf der einen Messung oder mehreren weiteren Messungen werden dann entsprechende weitere, zu unterschiedlichen Mess-Zeitdauern zugehörige Werte für den Innenwiderstand ermittelt.

Bevorzugt ist die erfindungsgemäße Batterie eine Lithium-Ionen-Batterie.

Außerdem wird erfindungsgemäß ein Kraftfahrzeug mit einem Elektromotor bereitgestellt, das das erfindungsgemäße Batteriesystem aufweist. Dabei ist das Batteriesystem mit dem Elektromotor verbunden.

Vorteilhafte Weiterbildungen der Erfindung sind in den Unteransprüchen angegeben und in der Beschreibung beschrieben.

Zeichnungen

Ausführungsbeispiele der Erfindung werden anhand der Zeichnungen und der nachfolgenden Beschreibung näher erläutert. Es zeigen:

Figur 1 ein Prinzipschaltbild eines Batteriemodulstrangs eines Batteriedirektkonverters, der eine stufig einstellbare Batterieausgangsspannung bereitstellt, gemäß dem Stand der Technik,

Figur 2 einen zeitlichen Verlauf eines Batteriestroms und einer Batteriezellenspannung während eines herkömmlichen Verfahrens zur Bestimmung des Innenwiderstands von Batteriezellen,

Figur 3 eine Ausführungsform des erfindungsgemäßen Batteriesystems, und

Figur 4 ein Diagramm, das die Abhängigkeit der Ausgangsspannung UB einer beispielhaften, in dem erfindungsgemäßen Batteriesystem eingesetzten Batterie von der Anzahl k der zu einem Batteriemodulstrang der Batterie zugeschalteten Batteriemodule darstellt.

Ausführungsformen der Erfindung

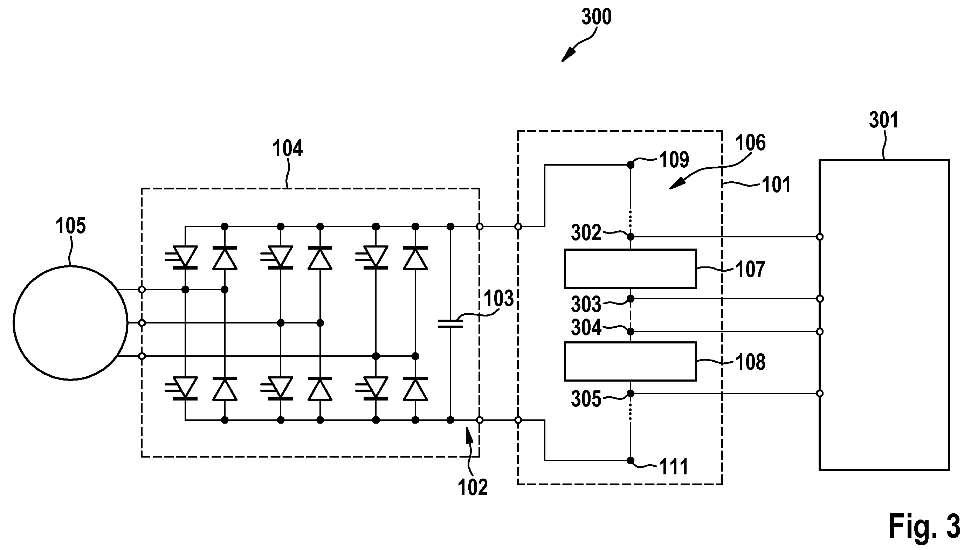

In Figur 3 wird eine Ausführungsform des erfindungsgemäßen Batteriesystems 300 gezeigt. Im Gegensatz zu dem Batteriesystem 100 aus Figur 1 weist das Batteriesystem 300, das gemäß der Architektur eines Batteriedirektkonverters aufgebaut ist, eine speziell angepasste Steuerungs- und Ausleseeinheit 301 auf, die die Zellüberwachungseinheiten (nicht dargestellt) und Stromsensoren (nicht dargestellt) des Batteriesystems 300 gemäß dem erfindungsgemäßen Verfahren ansteuert und ausliest. Dies wird in Abstimmung mit einer Ansteuerung der Batteriemodule 107, 108 ausgeführt. In der Figur 3 sind ferner Terminals 302, 303, 304, 305 der Batteriemodule 107, 108 dargestellt, mit denen die Batteriezellen (nicht dargestellt) modulweise entweder zugeschaltet oder entkoppelt werden können, wobei in dem nicht zugeschalteten Zustand beispielsweise des Batteriemoduls 107 die zugehörigen Terminals 302, 303 verbunden werden, so dass das Batteriemodul 107 überbrückt wird. Gleichzeitig kann sich ein anderes Batteriemodul, beispielsweise das mit dem Bezugszeichen 108 bezeichnete Batteriemodul, in einem zugeschalteten Zustand befinden, um an den zugehörigen Terminals 304, 305 eine Batteriemodulspannung bereitzustellen. In der in Figur 3 gezeigten Steuerungs- und Ausleseeinheit 301 ist ohne Beschränkung der Allgemeinheit mindestens eine Zellüberwachungseinheit (nicht dargestellt) integriert, mittels der die Batteriemodulspannungen und/oder die Zellspannungen über die Batteriemodulterminals ausgelesen werden.

Somit kann gemäß der Erfindung vorteilhafterweise die spezifische Arbeitsweise eines Batteriedirektkonverters oder einer Batterie 101 mit stufig einstellbarer Ausgangsspannung gezielt dazu genutzt werden, die Ermittlung des Innenwiderstands der in einem Batteriemodul 107, 108 des Batteriedirektkonverters enthaltenen Batteriezellen durchzuführen. Dazu wird jenes Batteriemodul 107, 108, für dessen Zellen die Innenwiderstände ermittelt werden sollen, während des Betriebs zugeschaltet. Damit wird der Strom, welcher durch die Batteriezellen dieses Batteriemoduls 107, 108 fließt, sprungförmig von 0 auf den aktuellen Ausgangsstrom der Batterie 100 erhöht. Die Batteriezellen des zugeschalteten Batteriemoduls 107, 108 antworten auf die sprungförmige Änderung ihres Stroms mit einer Änderung der Zellspannung. Diese Sprungantwort kann zusammen mit dem Batteriestrom in dem Batteriemanagementsystem aufgezeichnet werden. Damit stehen dem Batteriemanagementsystem die erforderlichen Informationen für die Innenwiderstandsbestimmung zur Verfügung.

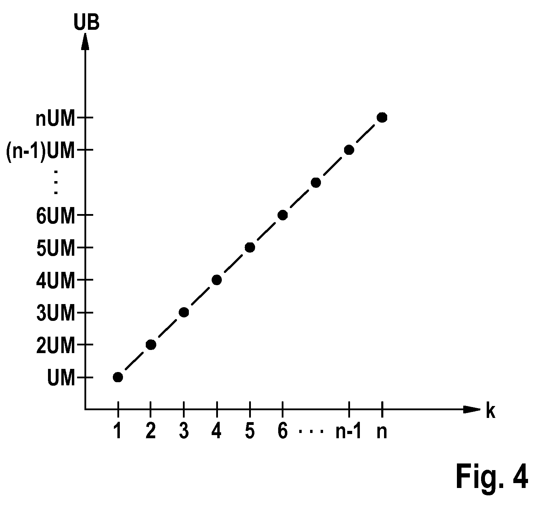

Figur 4 zeigt beispielhaft den Verlauf der Ausgangsspannung UB der Batterie 101 in Abhängigkeit von der Anzahl k der zu dem Batteriemodulstrang 106 zugeschalteten Batteriemodule 107, 108 für das in Figur 3 gezeigte erfindungsgemäße Batteriesystem 200. Die in Abhängigkeit von der zu dem Batteriemodulstrang 106 zugeschalteten Anzahl k von Batteriemodulen 107, 108 dargestellte Ausgangsspannung UB der Batterie 101 ist hierbei linear und folgt der Relation $UB = k \cdot UM$, wobei $1 < k < n$. Dabei ist n die maximale Anzahl der Batteriemodule 107, 108, die zu dem Batteriemodulstrang zugeschaltet werden kann. Die maximale Ausgangsspannung kann dann entsprechend den Wert $n \cdot UM$ annehmen, wobei die Punkte in der gezeigten linearen Spannungskurve die einzelnen Messungen symbolisieren.

Die Batteriemodule 107, 108 werden gemäß der Funktionsweise eines Batteriedirektkonverters entkoppelt oder zugeschaltet. Beispielsweise werden ein Einzelnes oder eine Mehrzahl von den Batteriemodulen 107, 108 zugeschaltet, und der Rest der Batteriemodule 107, 108 ist entkoppelt. Dann werden zumindest eines oder mehrere der zunächst noch entkoppelten Batteriemodule 107, 108 zugeschaltet. Gemäß diesem Prinzip kann eine Wechselspannung erzeugt werden. Dabei wird parallel, das heißt gleichzeitig, der Innenwiderstand der Batteriemodule 107, 108 gemessen und ausgewertet. Dabei ist der momentane Innenwiderstand insbesondere auch abhängig von der aktuell aus der Batterie entnommenen oder der Batterie zugeführten Leistung, welche wiederum von der momentanen Betriebssituation der Batterie und des Fahrzeugs abhängig ist. Im Folgenden sind dazu einige Beispiele angeführt, welche jeweils zueinander alternativ oder teilweise auch in Kombination ausgeführt werden können.

Gemäß einer Ausführungsform des erfindungsgemäßen Verfahrens wird für einen Entladevorgang der Batterie 101, beispielsweise bei einer Autobahnfahrt mit elektrischem Antrieb und konstanter Geschwindigkeit, über den Batteriedirektkonverter ein Batteriemodul 107, 108 zugeschaltet. Der Batteriestrom und die Spannungen der einzelnen Batteriezellen des Batteriemoduls 107, 108 werden aufgezeichnet. Dabei kann der Innenwiderstand $R_i$ der Batteriezellen gemäß der Formel

$$R_{i\_xs\_dch} = \frac{U_{I \mid xs} \quad U_I}{I_{I+xs}} \qquad (3)$$

ermittelt werden. Der Index I bezeichnet dabei den Zeitpunkt, bei dem das betreffende Batteriemodul 107, 108 zugeschaltet wird. Ferner beträgt die Zeitdauer, die das Batteriemodul 107, 108 bei Messung des Batteriemodulstroms bereits zu dem Batteriemodulstrang 106 zugeschaltet ist, x Sekunden. Der Zeitpunkt I+xs liegt somit x Sekunden nach dem Zuschaltzeitpunkt I. Daher kann auf diese Weise der Innenwiderstand $R_i$ beispielsweise für eine 2 Sekunden andauernde Entladung als $R_{i\_2s\_dch}$ bestimmt werden.

Zusätzlich zu den bei Entladevorgängen (dch) ("discharging") vorgenommenen Messungen kann das Verfahren auch bei Ladevorgängen (ch) ("charging") durchgeführt werden, um einen zugehörigen Innenwiderstandswert $R_{i\_2s\_dch}$ zu bestimmen.

Bei dem Verfahren werden bevorzugt die Innenwiderstände für alle Einzelzellen eines Batteriemoduls oder Batteriesystems bestimmt. Zusätzlich oder alternativ kann statt der Spannung der Einzelzellen kann auch die Batteriemodulspannung herangezogen werden, um so direkt den Innenwiderstand eines Batteriemoduls zu bestimmen.

Bei einer besonderen Ausführungsform des Verfahrens werden an den Stromverlauf zusätzliche Anforderungen gestellt. Beispielsweise darf der Strom sich während des Auswertezeitraums nach dem Zuschalten des Batteriemoduls nicht stärker verändern als ein vorgegebener Grenzwert. Dieser Grenzwert kann beispielsweise in Abhängigkeit von der Höhe des Stroms gewählt werden, so dass bei hohen Strömen größere Veränderungen zulässig sind als bei kleinen Strömen, und umgekehrt.

Gemäß einer Weiterbildung der Erfindung wird für das Batteriesystem ein Kennfeld mit den während verschiedener Messungen erhaltenen Daten abgelegt. So kann mit der Zeit eine immer genauere Charakterisierung des Innenwiderstandes erhalten werden, die jeweils genau auf die individuelle Fahrzeugsituation und die Umgebung des Batteriesystems zugeschnitten ist. So werden die Innenwiderstände als Funktion der Dauer der sprungförmigen Belastung, beispielsweise für Belastungen zwischen 1 s und 30 s, sowie als Funktion der Höhe des Lade- bzw. Entladestroms sowie der Einflussparameter Ladezustand und Temperatur abgelegt. Das Kennfeld wird ständig aktualisiert, um für alle Betriebsbereiche aktuelle Informationen über den Innenwiderstand zu haben.

Gemäß einer Ausführungsform der Erfindung wird während der Messdauer eine Veränderung einer Leerlaufspannung der Batteriezelle ermittelt, wobei der bei der Berechnung des Widerstandswertes verwendete Differenzspannungswert um den Wert der ermittelten Veränderung korrigiert wird. Auf diese Weise kann dem Umstand Rechnung getragen werden, dass bei größeren oder länger andauernden Lade- und Entladevorgängen mit hohen Strömen sich der Ladezustand der Batteriezellen während des Zeitintervalls, welches zur Bestimmung des Innenwiderstands herangezogen wird, bereits so ändert, dass die Innenwiderstandsbestimmung hiervon beeinflusst wird. Es kann somit berücksichtigt werden, dass sich die Ruhespannung beziehungsweise Leerlaufspannung (OCV) ("open circuit voltage") der Batterie abhängig vom Ladezustand ändert. Verfahrensgemäß kann diese Änderung wie folgt berücksichtigt werden:

$$R_i - \frac{\Delta U - \Delta OCV}{\Delta I} \qquad (4)$$

Dabei ist $\Delta OCV$ die ermittelte Änderung der Leerlaufspannung, $\Delta U$ die Spannungsdifferenz zwischen der Spannungsmessung zu einer ersten Zeit beim Zuschalten des Batteriemoduls und einer zweiten Zeit, nachdem das Batteriemodul eine vorbestimmte Zeitdauer zugeschaltet war, und $\Delta I$ ist die entsprechende Differenz des Batteriemodulstroms beziehungsweise Batteriemodulstrangstroms zwischen der ersten Zeit und der zweiten Zeit.

Beispielsweise wird bei dem in Figur 2 dargestellten Entladepuls zwischen t=0 s und t=18 s eine Ladung entnommen, welche einer relativen Ladezustandsänderung $\Delta SOC$ von 10 % entspricht. Die Ruhespannung einer Lithium-Ionen-Batteriezelle ändert sich bei einer solchen Ladezustandsänderung je nach Anfangsladezustand im Bereich von ca. 100 mV bis 280 mV, wobei der genaue Wert technologieabhängig ist. Dadurch ergibt sich zum Beispiel für eine herkömmliche 6Ah-Lithium-Ionen-Zelle, die bei Hybridfahrzeugen zum Einsatz kommt, bei Abzug der Spannungsänderung ein Innenwiderstand, der um den Wert

$$\Delta R_{i\_18s\_dch} = \frac{\Delta OCV}{\Delta I} = \frac{100mV \dots 280mV}{120A}$$
$$= 0{,}83m\Omega \dots 2{,}33m\Omega \qquad (5)$$

höher ist. Im Vergleich beträgt der Innenwiderstand der Batteriezelle, der sich nach Abzug der Ruhespannungsänderung für die beispielhaft betrachtete Zelle ergibt, ca. 2,2 mΩ. Somit kann, im Vergleich zu den herkömmlichen Verfahren, wo der Fehler teilweise mehr als 100 % betragen kann, bei dieser Ausführungsform der Erfindung eine signifikante Verbesserung der Genauigkeit der Innenwiderstandsbestimmung erreicht werden.

**Patentansprüche**

1. Verfahren zur Ermittlung des Innenwiderstandes von Batteriezellen oder von Batteriemodulen (107, 108) einer Batterie (101), die einen Batteriemodulstrang (106) mit einer Mehrzahl von in Serie geschalteten Batteriemodulen (107, 108) aufweist, die jeweils dazu ausgebildet sind, mittels von Steuersignalen wahlweise in einen zugeschalteten Zustand, in dem ein jeweiliges Batteriemodul (107, 108) zu einer Ausgangsspannung des Batteriemodulstrangs (106) beiträgt, oder einen nicht zugeschalteten Zustand, in dem das jeweilige Batteriemodul (107, 108) von dem Batteriemodulstrang (106) entkoppelt ist, schaltbar zu sein, **gekennzeichnet durch** die Schritte:

   a) Messen einer Spannung eines Batteriemoduls (107, 108) oder zumindest einer Batteriezelle eines Batteriemoduls (107, 108) zu einer ersten Zeit, zu der das Batteriemodul n (107, 108) nicht zu dem Batteriemodulstrang (106) zugeschaltet ist,
   b) Zuschalten des Batteriemoduls (107, 108) zu dem Batteriemodulstrang (106), so dass aufgrund eines **durch** das Batteriemodul (107, 108) fließenden Stroms eine Änderung der Spannung des Batteriemoduls (107, 108) oder der zumindest einen Batteriezelle erfolgt,
   c) Messen der Spannung des Batteriemoduls (107, 108) oder der Spannung der zumindest einen Batteriezelle zu einer zweiten Zeit, zu der das Batteriemodul (107, 108) eine vorbestimmte oder gewählte Zeitdauer zu dem Batteriemodulstrang (106) zugeschaltet ist, und
   d) Berechnen eines Widerstandswertes für den Innenwiderstand des Batteriemoduls (107, 108) beziehungsweise der zumindest einen Batteriezelle des Batteriemoduls (107, 108) anhand einer Differenz zwischen der zu der ersten Zeit gemessenen Spannung und der zu der zweiten Zeit gemessenen Spannung und des Stromwertes des **durch** das Batteriemodul (107, 108) fließenden Stroms.

2. Verfahren nach Anspruch 1, wobei der Stromwert des durch das Batteriemodul (107, 108) fließenden Stroms zu der zweiten Zeit gemessen wird.

3. Verfahren nach Anspruch 1 oder 2, wobei das Verfahren während eines Ladevorgangs der Batterie (101) oder während eines Entladevorgangs der Batterie (101) durchgeführt wird.

4. Verfahren nach einem der vorhergehenden Ansprüche, wobei ferner ermittelt wird, ob die Höhe einer Änderung des während der Zeitdauer, in der das Batteriemodul (107, 108) dem Batteriemodulstrang (106) zugeschaltet ist, durch das Batteriemodul (107, 108) fließenden Stroms einen vorbestimmten Grenzwert überschreitet oder nicht, und falls ermittelt wird, dass eine Überschreitung des Grenzwerts vorliegt, eine gemessene Spannung verworfen und/oder das Verfahren neu bei Schritt a) gestartet wird.

5. Verfahren nach einem der vorhergehenden Ansprüche, wobei ferner eine während der vorbestimmten Zeitdauer auftretende Veränderung der Leerlaufspannung des Batteriemoduls (107, 108) beziehungsweise der Leerlaufspannung der zumindest einen Batteriezelle ermittelt wird und wobei der bei der Berechnung des Widerstandswertes verwendete Differenzspannungswert um den Wert der ermittelten Veränderung korrigiert wird.

6. Verfahren nach einem der vorhergehenden Ansprüche, wobei das Verfahren mehrfach durchgeführt bei unterschiedlichen Randbedingungen, wie Ladezustand, Temperatur, Höhe des Lade- oder Entladestroms, und/oder mit einer jeweils unterschiedlich gewählten Zeitdauer zwischen der ersten Spannungsmessung und der zweiten Spannungsmessung und wobei die bei den mehrfachen Durchführungen des Verfahrens ermittelten Messdaten in Form eines Innenwiderstands-Kennfelds abgelegt werden.

7. Verfahren einem der vorhergehenden Ansprüche, wobei nach dem Verfahrensschritt c) und bevor das Batteriemodul (107, 108) wieder in den nicht zugeschalteten Zustand geschaltet wird, eine oder mehrere weitere Messungen der Spannung des Batteriemoduls (107, 108) beziehungsweise der Spannung der zumindest einen Batteriezelle des Batteriemoduls (107, 108) durchführt werden und, basierend auf der einen Messung oder mehreren weiteren Messungen, entsprechende weitere, unterschiedlichen Mess-Zeitdauern zugehörige Werte für den Innenwiderstand ermittelt werden.

8. Batteriesystem (300) mit einer Batterie (101), die einen Batteriemodulstrang (106) mit einer Mehrzahl von in Serie geschalteten Batteriemodulen (107, 108) aufweist, die jeweils mindestens eine Batteriezelle und eine ansteuerbare Koppeleinheit umfassen, mit mindestens einer zur Überwachung der Batteriemodule (107, 108) der Batterie (101) vorgesehenen Überwachungseinheit, die dazu ausgebildet ist, Zellspannungen und/oder Batteriemodulspannungen zu messen, und mit mindestens einer mit dem Batteriemodulstrang (106) verschalteten Strommesseinheit, wobei die Batteriemodule (107, 108) zur Erzeugung einer einstellbaren Ausgangsspannung der Batterie (101) mittels der Koppeleinheiten jeweils selektiv dem Batteriemodulstrang (106) zugeschaltet und wieder entkoppelt werden können, **dadurch gekennzeichnet, dass** das Batteriesystem (300) eine Steuerungs- und Ausleseeinheit (301), die mit den Koppeleinheiten, mit der mindestens einen Überwachungseinheit, und mit der Strommesseinheit verbunden ist, aufweist und ausgebildet ist, das Verfahren nach einem der vorhergehenden Ansprüche zur Ermittlung des Innenwiderstands von Batteriemodulen (107, 108) oder von Batteriezellen des Batteriesystems (300) durchzuführen.

9. Batteriesystem (300) nach Anspruch 8, wobei die Batterie (101) eine Mehrzahl von Batteriemodulsträngen (106) umfasst und dazu eingerichtet ist, durch Ansteuerung der Koppeleinheiten mittels der Batteriemodulstränge (106) zueinander phasenversetzte Wechselspannungen, insbesondere zum Betrieb eines Dreiphasen-Elektromotors zu erzeugen und das Verfahren nach einem der Ansprüche 1 bis 7 basierend auf den zur Erzeugung der phasenversetzten Wechselspannungen vorgenommenen Zuschaltungen und Entkopplungen von Batteriemodulen (107, 108) durchzuführen.

10. Kraftfahrzeug mit einem Elektromotor und dem Batteriesystem (300) nach einem der Ansprüche 8 bis 9, wobei das Batteriesystem (300) mit dem Elektromotor (105) verbunden ist.

## Claims

1. Method for determining the internal resistance of battery cells or of battery modules (107, 108) of a battery (101) which has a battery module string (106) with a plurality of series-connected battery modules (107, 108) which are each designed to be selectively switchable into a connected state, in which a respective battery module (107, 108) contributes to an output voltage of the battery module string (106), or into a disconnected state, in which the respective battery module (107, 108) is decoupled from the battery module string (106), by means of control signals, **characterized by** the steps of:

   a) measuring a voltage of a battery module (107, 108) or at least one battery cell of a battery module (107, 108) at a first time, at which the battery module n (107, 108) is not connected to the battery module string (106),
   b) connecting the battery module (107, 108) to the battery module string (106), with the result that a change in the voltage of the battery module (107, 108) or of the at least one battery cell occurs owing to a current flowing through the battery module (107, 108),
   c) measuring the voltage of the battery module (107, 108) or the voltage of the at least one battery cell at a second time, at which the battery module (107, 108) has been connected to the battery module string (106) for a predefined or selected time interval, and
   d) calculating a resistance value for the internal resistance of the battery module (107, 108) or for the at least one battery cell of the battery module (107, 108) on the basis of a difference between the voltage measured at the first time and the voltage measured at the second time and of the current value of the current flowing through the battery module (107, 108).

2. Method according to Claim 1, wherein the current value of the current flowing through the battery module (107, 108) is measured at the second time.

3. Method according to Claim 1 or 2, wherein the method is performed during a charging process of the battery (101) or during a discharging process of the battery (101).

4. Method according to any of the preceding claims, wherein it is also determined whether or not the level of a change in the current flowing through the battery module (107, 108) during the time interval in which the battery module (107, 108) is connected to the battery module string (106) exceeds a predefined limit value and, if it is determined that the limit value has been exceeded, a measured voltage is discarded and/or the method is started again at step a).

5. Method according to any of the preceding claims, wherein a change in the open circuit voltage of the battery module (107, 108) or in the open circuit voltage of the at least one battery cell occurring during the predefined time interval is also determined and wherein the difference voltage value used in the calculation of the resistance value is corrected by the value of the determined change.

6. Method according to any of the preceding claims, wherein the method is performed multiple times under different boundary conditions, such as state of charge, temperature, level of the charging or discharging current, and/or with a respectively differently selected time interval between the first voltage measurement and the second voltage measurement and wherein the measured data determined during the multiple performances of the method is stored in the form of an internal resistance characteristic.

7. Method according to any of the preceding claims, wherein one or more further measurements of the voltage of the battery module (107, 108) or of the voltage of the at least one battery cell of the battery module (107, 108) are performed after the method step c) and before the battery module (107, 108) is switched into the disconnected state again and, on the basis of the one measurement or plurality of further measurements, corresponding further values, associated with different measurement time intervals, are determined for the internal resistance.

8. Battery system (300) having a battery (101) which has a battery module string (106) with a plurality of series-connected battery modules (107, 108), which each comprise at least one battery cell and an actuable coupling unit, having at least one monitoring unit provided for monitoring the battery modules (107, 108) of the battery (101), which monitoring unit is designed to measure cell voltages and/or battery module voltages, and having at least one current measuring unit which is interconnected with the battery module string (106), wherein the battery modules (107, 108) can each be selectively connected to and decoupled again from the battery module string (106) by means of the coupling units in order to generate a settable output voltage of the battery (101), **characterized in that** the battery system (300) has a control and readout unit (301), which is connected to the coupling units, to the at least one monitoring unit and to the current measuring unit, and is designed to perform the method according to any of the preceding claims for determining the internal resistance of battery modules (107, 108) or of battery cells of the battery system (300).

9. Battery system (300) according to Claim 8, wherein the battery (101) comprises a plurality of battery module strings (106) and is set up to generate, by actuating the coupling units by means of the battery module strings (106), AC voltages which are phase-shifted with respect to one another, in particular for operating a three-phase electric motor, and to perform the method according to any of claims 1 to 7 on the basis of the connections and decouplings of battery modules (107, 108) performed for the generation of the phase-shifted AC voltages.

10. Motor vehicle having an electric motor and the battery system (300) according to any of Claims 8 to 9, wherein the battery system (300) is connected to the electric motor (105).

**Revendications**

1. Procédé de détermination de la résistance interne des cellules de batterie ou des modules de batterie (107, 108) d'une batterie (101), laquelle possède une branche de modules de batterie (106) avec une pluralité de modules de batterie (107, 108) branchés en série, lesquels sont respectivement configurés pour pouvoir être commutés au choix, au moyen de signaux de commande, dans un état de mise en circuit, dans lequel un module de batterie (107, 108) respectif contribue à une tension de sortie de la branche de modules de batterie (106), ou dans un état de mise hors circuit, dans lequel le module de batterie (107, 108) respectif est déconnecté de la branche de modules de batterie (106), **caractérisé par** les étapes suivantes :

a) mesure d'une tension d'un module de batterie (107, 108) ou d'au moins une cellule de batterie d'un module de batterie (107, 108) à un premier instant auquel le module de batterie n (107, 108) n'est pas mis en circuit dans la branche de modules de batterie (106),
b) mise en circuit du module de batterie (107, 108) dans la branche de modules de batterie (106), de sorte qu'un courant qui circule à travers le module de batterie (107, 108) entraîne une modification de la tension du module de batterie (107, 108) ou de l'au moins une cellule de batterie,
c) mesure de la tension du module de batterie (107, 108) ou de la tension de l'au moins une cellule de batterie à un deuxième instant auquel le module de batterie (107, 108) est mis en circuit dans la branche de modules de batterie (106) pendant une durée prédéfinie ou choisie, et
d) calcul d'une valeur de résistance pour la résistance interne du module de batterie (107, 108) ou de l'au moins une cellule de batterie du module de batterie (107, 108) au moyen d'une différence entre la tension mesurée au premier instant et la tension mesurée au deuxième instant et de l'intensité du courant qui circule à travers le module de batterie (107, 108).

2. Procédé selon la revendication 1, l'intensité du courant qui circule à travers le module de batterie (107, 108) étant mesurée au deuxième instant.

3. Procédé selon la revendication 1 ou 2, le procédé étant mis en oeuvre pendant une opération de charge de la batterie (101) ou pendant une opération de décharge de la batterie (101).

4. Procédé selon l'une des revendications précédentes, une détermination étant en outre effectuée afin de vérifier si le niveau d'une modification du courant qui circule à travers le module de batterie (107, 108), pendant la durée où le module de batterie (107, 108) est mis en circuit dans la branche de modules de batterie (106), dépasse ou non une valeur limite prédéfinie, et si un dépassement de la valeur limite est déterminé, une tension mesurée est rejetée et/ou le procédé recommence à l'étape a).

5. Procédé selon l'une des revendications précédentes, une modification de la tension à vide du module de batterie (107, 108) ou de la tension à vide de l'au moins une cellule de batterie qui se produit pendant la durée prédéfinie étant en outre déterminée et la valeur de la différence de tension utilisée lors du calcul de la valeur de résistance étant corrigée de la valeur de la modification déterminée.

6. Procédé selon l'une des revendications précédentes, le procédé étant mis en oeuvre plusieurs fois avec des conditions aux limites différentes, comme l'état de charge, la température, l'intensité du courant de charge ou de décharge, et/ou avec une durée respectivement choisie différente entre la première mesure de tension et la deuxième mesure de tension, et les données mesurées déterminées lors des multiples mises en oeuvre du procédé étant enregistrées sous la forme d'un diagramme caractéristique de la résistance interne.

7. Procédé selon l'une des revendications précédentes, une ou plusieurs mesures supplémentaires de la tension du module de batterie (107, 108) ou de la tension de l'au moins une cellule de batterie du module de batterie (107, 108) étant effectuées après l'étape c) du procédé et avant que le module de batterie (107, 108) soit de nouveau commuté dans l'état de mise hors circuit, et des valeurs supplémentaires correspondantes de la résistance interne, associées à des durées de mesure différentes, sont déterminées en se basant sur la mesure ou sur les plusieurs mesures supplémentaires.

8. Système de batterie (300) comprenant une batterie (101) qui possède une branche de modules de batterie (106) avec une pluralité de modules de batterie (107, 108) branchés en série, lesquels comprennent respectivement au moins une cellule de batterie et une unité de connexion commandable, comprenant au moins une unité de surveillance conçue pour la surveillance des modules de batterie (107, 108) de la batterie (101), laquelle est conçue pour mesurer les tensions de cellule et/ou les tensions de module de batterie, et comprenant au moins une unité de mesure de courant interconnectée à la branche de modules de batterie (106), les modules de batterie (107, 108) pouvant respectivement être mis en circuit dans la branche de modules de batterie (106) et de nouveau en être déconnectés de manière sélective au moyen des unités de connexion en vue de générer une tension de sortie réglable de la batterie (101), **caractérisé en ce que** le système de batterie (300) possède une unité de commande et de lecture (301) qui est reliée aux unités de connexion, à l'au moins une unité de surveillance et à l'unité de mesure de courant et qui est configurée pour mettre en oeuvre le procédé selon l'une des revendications précédentes pour déterminer la résistance interne de modules de batterie (107, 108) ou de cellules de batterie du système de batterie (300).

9. Système de batterie (300) selon la revendication 8, la batterie (101) comprenant une pluralité de branches de modules de batterie (106) et étant configuré pour générer, au moyen des branches de modules de batterie (106) et en commandant les unités de connexion, des tensions alternatives mutuellement déphasées, notamment destinées au fonctionnement d'un moteur électrique triphasé, et pour mettre en oeuvre le procédé selon l'une des revendications 1 à 7 en se basant sur les mises en circuit et les déconnexions des modules de batterie (107, 108) effectuées en vue de générer les tensions alternatives déphasées.

10. Véhicule automobile équipé d'un moteur électrique et du système de batterie (300) selon l'une des revendications 8 à 9, le système de batterie (300) étant relié au moteur électrique (105).

Fig. 1
( Stand der Technik )

Fig. 2
( Stand der Technik )

EP 2 859 367 B1

Fig. 3

Fig. 4

**IN DER BESCHREIBUNG AUFGEFÜHRTE DOKUMENTE**

**In der Beschreibung aufgeführte Patentdokumente**

- DE 102009002465 A1